# EUROPEAN PATENT APPLICATION

(11) **EP 3 576 495 A1**
(43) Date of publication of application: **04.12.2019**
(21) Application number: 18182659.5
(22) Date of filing: 10.07.2018
(51) Int. Cl.: H05B 33/08

(54) **LUMINANCE AND COLOR TEMPERATURE TUNABLE LIGHT SOURCE**

(30) Priority: 30.05.2018 TW 107118492
(71) Applicant: National Tsing Hua University, Hsinchu (TW)
(72) Inventor: JWO-HUEI, JOU, Hsinchu (TW); CHENG-CHIEH, LO, Hsinchu (TW); HSIN-FA, LIN, Hsinchu (TW)
(74) Representative: Becker Kurig Straus

(57) **Abstract**

Disclosures of the present invention describe a luminance and color temperature tunable light source consisting of a plurality of lighting elements and a plurality of light conversion units, wherein parts of the lighting elements are connected with one light conversion unit by a light emission surface thereof. According to the particular design of the present invention, part of the light conversion units comprise only one light conversion film and the other part of the light conversion units comprise two or more light conversion film stacked to each other. By such design, when the lighting elements emit light with high color temperature, the light conversion unit would apply a light conversion process to the light, so as to modulate the color temperature and the luminance of the light. Therefore, the light source proposed by the present invention succeeds in exhibiting a brightness and color temperature individually-tunable function.

## Description

### BACKGROUND OF THE INVENTION

### 1. Field of the Invention

The present invention relates to the technology field of light sources, and more particularly to a luminance and color temperature tunable light source.

### 2. Description of the Prior Art

With the development of optoelectronics industry, more and more types of lighting elements or devices are developed and then proposed. Light-emitting devices (LEDs) are now widely used as primary light-emitting elements of an illumination device, and can be divided into high color temperature (CT) LED components and low CT LED components. When the high CT LED components are applied in one illumination device, light radiated from the illumination device would be classified to cold light because of having CT of above 6,500 K. On the contrary, after the high CT LED components are applied in another one illumination device, light radiated from the illumination device is therefore classified to warm light because of having CT of above 2,500 K.

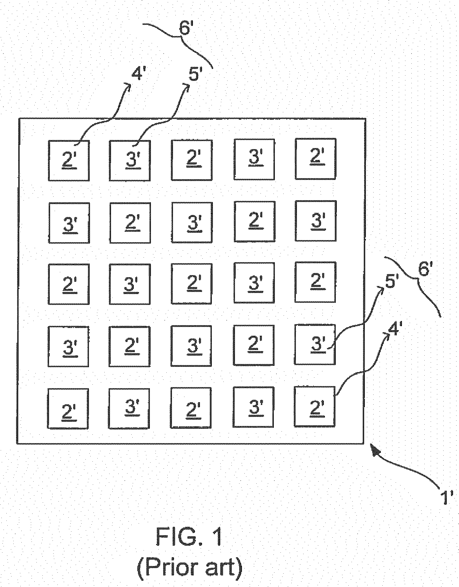

Due to the fact that human eye is not equally sensitive to warm light and cold light, illumination device manufacturers accordingly provide a CT tunable illumination device. FIG. 1 shows a framework diagram of a conventional CT tunable illumination device. From FIG. 1, it is understood that the CT tunable illumination device 1' mainly comprises a lighting array consisting of a plurality of first LEDs 2' for emitting a warm light 4' having CT of 2,500-4,000 K and a plurality of second LEDs 3' for emitting a cold light 5' having CT of 6,000-10,000 K. It is noted that, a light 6' provided by the illumination device 1' is a combination (or mixture) of the warm light 4' and the cold light 5', and the color temperature of the light 6' is dependent on a contribution ratio between the warm light 4' and the cold light 5'.

Although the illumination device 1' shown in FIG. 1 indeed provides CT tunable function for users, electronic engineers skilled in development and manufacture of illumination devices find that the illumination device 1' still exhibits some drawbacks in practical use. The drawbacks are summarized as follows:
(1) Because the CT adjusting capability of the CT tunable illumination device 1' is relied on the CT tunable range of the first LEDs 2' and the second LEDs 3', the CT tunable range of the light 6' radiated by the illumination device 1' is hence limited.
(2) It needs to increase or reduce the driving voltage or driving current of the first LEDs 2' and the second LEDs 3' in order to adjust the brightness or illuminance of the illumination device 1'. However, in the case of the increasing of the driving voltage (current), color temperature of the light 6' would rise because the blue light ratio in the light 6' is increased. Briefly speaking, color temperature of the light 6' radiated by the illumination device 1' commonly rises when the brightness or illuminance is adjusted upward, causing the illumination device 1' fail to has a brightness and color temperature individually-tunable function.

From above descriptions, it is clear that how to design an illumination device capable of exhibiting brightness and color temperature individually-tunable function has now become an important issue. Accordingly, the inventors of the present application have made great efforts to make inventive research thereon and eventually provided a luminance and color temperature tunable light source.

### SUMMARY OF THE INVENTION

Conventional technology commonly provides a color temperature (CT) tunable illumination apparatus by constituting a plurality of high CT lighting devices and low CT lighting elements. However, not only does the high CT and low CT lighting elements lead the illumination apparatus to have a high manufacture cost and be difficult to be fabricated, but also cause the illumination apparatus have a limited CT tunable range because the CT adjusting capability is relied on a CT tunable range of the two types of lighting elements. In view of that, the primary objective of the present invention is to provide a luminance and color temperature tunable light source comprising a plurality of lighting elements and a plurality of light conversion units, wherein parts of the lighting elements are connected with one light conversion unit by a light emission surface thereof. In the present invention, part of the light conversion units comprise only one light conversion film and the other part of the light conversion units comprise two or more light conversion film stacked to each other. By such design, when the lighting elements emit light with high color temperature, the light conversion unit would apply a light conversion process to the light, so as to modulate the color temperature and the luminance of the light. Therefore, the light source proposed by the present invention succeeds in exhibiting a brightness and color temperature individually-tunable function.

In order to achieve the primary objective of the present invention, the inventor of the present invention provides one embodiment for the luminance and color temperature tunable light source, comprising
a plurality of lighting elements, wherein each of the plurality of lighting elements is configured to emit a high color temperature light;
a plurality of light conversion units, wherein parts of the lighting elements are connected with one light conversion unit by the light emission surface thereof;
wherein part of the light conversion units are one light conversion film, and the other part of the light conversion units comprising two or more light conversion film stacked to each other;
wherein the light conversion unit is configured for changing the color temperature and the luminance of the high color temperature light.

The embodiment of the luminance and color temperature tunable light source further comprises:
a driver module, comprising a plurality electrical connection members for being electrically connected to the lighting elements; and
a controlling module, being electrically connected to the driver module.

In the embodiment of the luminance and color temperature tunable light source, the light conversion film comprises a substrate made of at least one polymer matrix and a plurality of light conversion particles doped in or enclosed by the polymer matrix.

### BRIEF DESCRIPTION OF THE DRAWINGS

The invention as well as a preferred mode of use and advantages thereof will be best understood by referring to the following detailed description of an illustrative embodiment in conjunction with the accompanying drawings, wherein:
FIG. 1 shows a framework diagram of a conventional CT tunable illumination device;
FIG. 2 shows a framework diagram of a luminance and color temperature tunable light source according to the present invention;
FIG. 3 shows a cross-sectional view of a substrate, multi light-emitting elements, and multi light conversion units;
FIG. 4 shows a cross-sectional view of a substrate, one light-emitting element, and one light conversion unit;
FIG. 5 shows a stereo diagram for depicting a first exemplary embodiment of the luminance and color temperature tunable light source;
FIG. 6 shows a stereo diagram for depicting a second exemplary embodiment of the luminance and color temperature tunable light source; and
FIG. 7 shows a stereo diagram for depicting a third exemplary embodiment of the luminance and color temperature tunable light source.

### DETAILED DESCRIPTION OF THE PREFERRED EMBODIMENTS

To more clearly describe a luminance and color temperature tunable light source according to the present invention, embodiments of the present invention will be described in detail with reference to the attached drawings hereinafter.

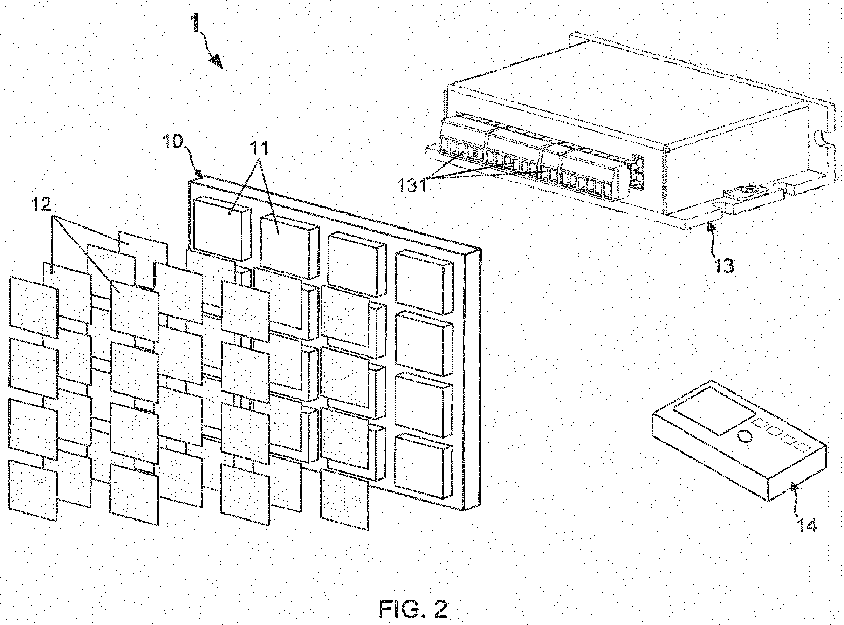

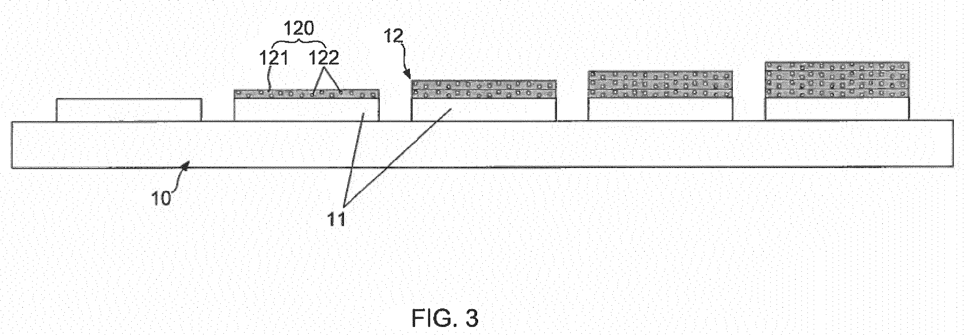

With reference to FIG. 2, there is a framework diagram of a luminance and color temperature tunable light source according to the present invention. As FIG. 2 shows, the luminance and color temperature tunable light source 1 (abbreviated to "illumination device 1", hereinafter) of the present invention mainly comprises a plurality of lighting elements 11, a plurality of light conversion units, a driver module 13, and a controlling module 14, wherein the lighting elements 11 are arranged on a substrate 10. Please simultaneously refer to FIG. 3, which illustrates a cross-sectional view of the substrate, multi light-emitting elements, and multi light conversion units. From FIG. 2 and FIG. 3, it is understood that parts of the lighting elements 11 are connected with one light conversion unit 12 by the light emission surface thereof. In the present invention, it is particularly noteworthy that part of the light conversion units are one light conversion film 120, and the other part of the light conversion units comprise two or more light conversion film 120 stacked to each other.

Please refer to FIG. 2 and FIG. 3 again. The driver module 13 comprises a plurality of electrical connection members 131 for being electrically connected to the lighting elements 11, so as to driving each of the lighting elements to emit a light with high color temperature. In addition, the substrate 10 is provided with a circuit thereon for making the lighting elements 11 electrically connecting the electrical connection members 131 via the circuit. In the present invention, the light conversion unit 12 (i.e., the light conversion film(s)) is configured for applying a wavelength converting treatment to the light radiated from the lighting element 11. It is interesting that both the color temperature and the luminance of the light are also be changed after the wavelength converting treatment is completed. It is worth mentioning that, comparing the light conversion unit 12 made of one light conversion film 120, the light conversion unit 12 constituted by two or more stacked light conversion films 120 shows an apparent effect on reducing the color temperature and the luminance of the light. Experimental data for describing the reduction of color temperature and the luminance of the light in response to the stack numbers of the light conversion films 120 are listed in following Table (1).

**Table (1)**

| Stack numbers of the light conversion films | Color temperature of the light radiated from the lighting element (K) | Luminance of the light radiated from the lighting element (lx) | CIE coordinates (x,y) |
|---|---|---|---|
| 0 | 4920 | 4020 | (0.34,0.32) |
| 1 | 3575 | 3040 | (0.39,0.35) |
| 2 | 2788 | 2230 | (0.43,0.37) |
| 3 | 2403 | 1180 | (0.46,0.38) |
| 4 | 2138 | 839 | (0.49,0.38) |
| 5 | 1852 | 634 | (0.52,0.39) |

Herein, it needs to further explain that, the experimental data of Table (1) can still support the statement of "the light conversion unit 12 constituted by two or more stacked light conversion films 120 shows better effect on reducing the color temperature and the luminance of the light" in spite of the fact that the original color temperature of the light is merely 4,920 K (belong to medium color temperature). Therefore, it is easy for users to control this luminance and color temperature tunable light source 1 to provide an illumination with specific color temperature and luminance by operating the driver module 13 to drive part or all of the lighting elements to emit light. For example, it is able to modulate the luminance of a light emitted by an OLED (i.e., the lighting element 11) in a range between 212 cd/m² and 13,570 cd/m², wherein the original color temperature of the light is 5,219 K. However, for another one identical OLED connected with two stacked light conversion films 120, the luminance of the light thereof can be modulated in a range from 108 cd/m²to 6,817 cd/m², wherein the color temperature of the light is reduced to 3,549 K. Furthermore, when a light conversion unit 12 consists of five light conversion films is connected to the light emission surface of the OLED, color temperature of the light radiated from the OLED is reduced to 1,852 K; moreover, the luminance of the light is modulated in a range between 42 cd/m² and 2,724 cd/m².

In the present invention, the light conversion film 120 comprises a substrate 121 made of at least one polymer matrix and a plurality of light conversion particles 122 doped in or enclosed by the polymer matrix, wherein the polymer matrix is made of a specific material selected from the group consisting of polydimethylsiloxane (PDMS), polystyrene (PS), polyethylene terephthalate (PET), polycarbonate (PC), cycloolefin co-polymer (COC), cyclic block copolymer (CBC), polylactide (PLA), polyimide (PI), and combination of the aforesaid two or above materials.

On the other hand, the light conversion particles 121 are quantum dots or phosphor particles. Due to quantum scale effect of quantum dots (QDs), QDs of different sizes can emit excitation fluorescence light with different colors. Relations between the fluorescence color of the excitation light and the QDs sizes are summarized in following Table (2).

**Table (2)**

| Fluorescence color of the excitation light | Size of QDs |
|---|---|
| Blue-green | 2-7nm |
| Green | 3-10nm |
| Yellow | 4-12nm |
| Orange | 4-14nm |
| Red | 5-20nm |

The quantum dot is selected from the group consisting of Group II-VI compounds, Group III-V compounds, Group II-VI compounds having core-shell structure, Group III-V compounds having core-shell structure, Group II-VI compounds having non-spherical alloy structure, and combination of the aforesaid two or above compounds. On the other hand, the phosphor can be aluminate phosphor, silicate phosphor, phosphate phosphor, sulfide phosphor, or nitride phosphor.

Exemplary materials of the fluorescent powder (phosphor) and the quantum dots for being used as the light conversion particles are integrated and listed in following Table (3) and Table (4).

**Table (3)**

| Types of quantum dot (QD) | Corresponding exemplary material |
|---|---|
| Group II-VI compounds | CdSe or CdS |
| Group III-V compounds | (Al, In, Ga)P, (Al, In, Ga)As, or (Al, In. Ga)N |
| Group III-V compounds having core-shell structure | CdSe/ZnS core-shell QD |
| Group III-V compounds having core-shell structure | InP/ZnS core-shell QD |
| Group II-VI compounds having non-spherical alloy structure | ZnCdSeS |

**Table (4)**

| Types of fluorescent powder | Corresponding exemplary material |
|---|---|
| Aluminate phosphor | Eu doped Y-Al-O multi-composition phosphor |
| Silicate phosphor | Ca₃Si₂O₇:Eu²⁺ |
| Phosphate phosphor | KSr₁₋ₓPO₄:Tbₓ |
| | K₂SiF₆:Mn⁴⁺ (KSF) |
| Sulfide phosphor | ZnS:X |
| | X = Au, Ag, Cu, Mn, Cd |
| Nitride phosphor | β-SiAlON:Eu²⁺ |
| Other-type phosphor | SrGa₂S₄:Eu²⁺ (SGS) |

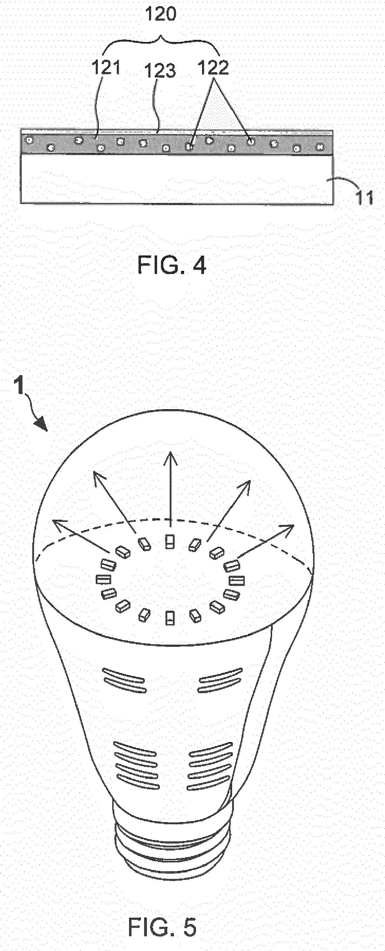

It needs to emphasize that, the exemplary materials listed in above Table (3) and Table (4) are not used for imitating the manufacturing material of the light conversion particles 122. Please continuously refer to FIG. 4, wherein a cross-sectional view of the substrate, the light-emitting element, and the light conversion unit is provided. When the light conversion film 120 is constituted by a substrate 121 and a plurality of light conversion particles 122 doped in the substrate 121, it is able to further formed an oxygen and moisture barrier on the light conversion film 120. The oxygen and moisture barrier is made of a specific material selected from the group consisting of polyethylene terephthalate (PET), polyethylene naphthalate (PEN), poly(methyl methacrylate) (PMMA), silica, titanium oxide, aluminum oxide, and combination of the aforesaid two or above materials.

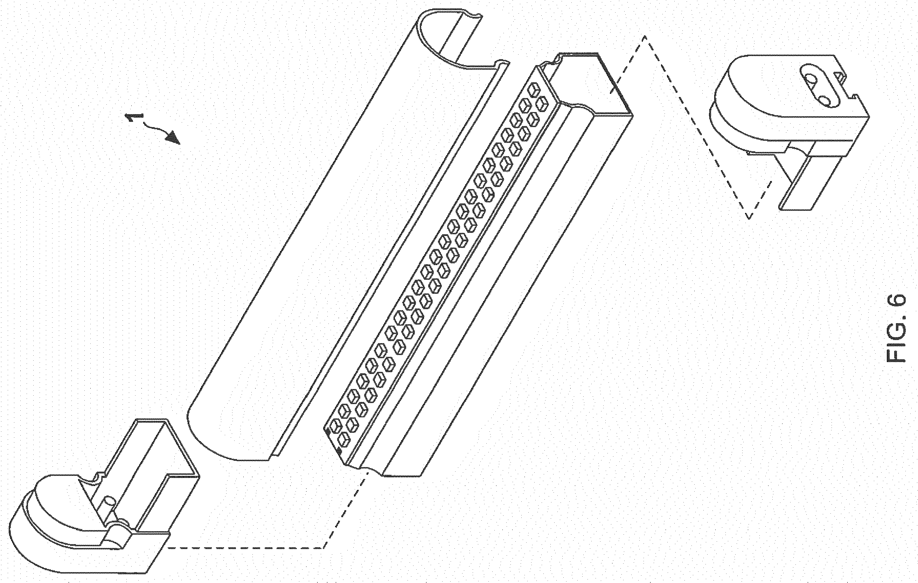

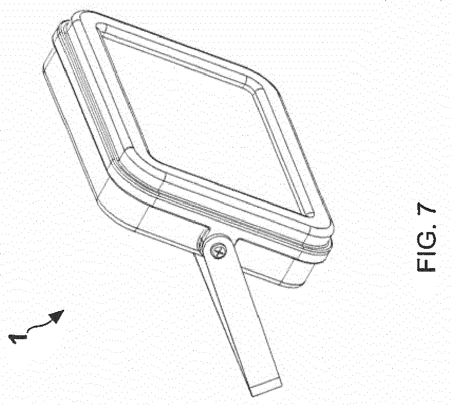

In addition, it needs to further explain that, the light conversion film 120 can also be constituted by a transparent substrate and at least one light converting coating layer formed on the transparent substrate, such that the light conversion unit(s) 12 comprising one or more light conversion films 120 is facilitated be applied in other lighting device. FIG. 5, FIG. 6 and FIG. 7 show stereo diagrams for respectively depicting a first exemplary embodiment, a second exemplary embodiment and a third exemplary embodiment of the luminance and color temperature tunable light source. From FIG. 5, FIG. 6 and FIG. 7, it is understood that the luminance and color temperature tunable light source 1 of the present invention have many types of exemplary embodiment, such as tube type lighting apparatus, planar lighting apparatus, and light bulb. Besides, due to the fact that various lighting apparatuses may using different types of lighting elements, the present invention does not limit the type of the lighting elements 11, which can be a fluorescent lamp, an LED, a quantum dots LED, or an OLED, or a combination of aforesaid two or more devices.

Therefore, through above descriptions, the luminance and color temperature tunable light source 1 proposed by the present invention has been introduced completely and clearly; in summary, the present invention includes the advantages of:

(1) Conventional technology commonly provides a color temperature (CT) tunable illumination apparatus by constituting a plurality of high CT lighting devices and low CT lighting elements. However, not only does the high CT and low CT lighting elements lead the illumination apparatus to have a high manufacture cost and be difficult to be fabricated, but also cause the illumination apparatus have a limited CT tunable range because the CT adjusting capability is relied on a CT tunable range of the two types of lighting elements. In view of that, the present invention discloses a luminance and color temperature tunable light source 1 comprising a plurality of lighting elements 11 and a plurality of light conversion units 12, wherein parts of the lighting elements 11 are connected with one light conversion unit 12 by a light emission surface thereof. In the present invention, part of the light conversion units 12 comprise only one light conversion film 120 and the other part of the light conversion units 12 comprise two or more light conversion film 120 stacked to each other. By such design, when the lighting elements 11 emit light with high color temperature, the light conversion unit 12 would apply a light conversion process to the light, so as to modulate the color temperature and the luminance of the light. Therefore, the light source 1 proposed by the present invention succeeds in exhibiting a brightness and color temperature individually-tunable function.

The above description is made on embodiments of the present invention. However, the embodiments are not intended to limit scope of the present invention, and all equivalent implementations or alterations within the spirit of the present invention still fall within the scope of the present invention.

## Claims

1. A luminance and color temperature tunable light source, comprising:
a plurality of lighting elements, wherein each of the plurality of lighting elements is configured to emit a high color temperature light;
a plurality of light conversion units, wherein parts of the lighting elements are connected with one light conversion unit by the light emission surface thereof;
wherein part of the light conversion units are one light conversion film, and the other part of the light conversion units comprising two or more light conversion film stacked to each other;
wherein the light conversion unit is configured for changing the color temperature and the luminance of the high color temperature light.

2. The luminance and color temperature tunable light source of claim 1, further comprising:
a driver module, comprising a plurality of electrical connection members for being electrically connected to the lighting elements; and
a controlling module, being electrically connected to the driver module.

3. The luminance and color temperature tunable light source of claim 1, further comprising a substrate for supporting the lighting elements.

4. The luminance and color temperature tunable light source of claim 1, wherein the lighting element is selected from the group consisting of fluorescent lamp, LED, quantum dots LED, OLED, combination of aforesaid two or more devices.

5. The luminance and color temperature tunable light source of claim 1, wherein the light conversion film comprises a substrate made of at least one polymer matrix and a plurality of light conversion particles doped in or enclosed by the polymer matrix.

6. The luminance and color temperature tunable light source of claim 3, wherein a circuit is disposed on the substrate for connecting between the lighting elements and the electrical connection members.

7. The luminance and color temperature tunable light source of claim 5, wherein the polymer matrix is made of a specific material selected from the group consisting of polydimethylsiloxane (PDMS), polystyrene (PS), polyethylene terephthalate (PET), polycarbonate (PC), cycloolefin co-polymer (COC), cyclic block copolymer (CBC), polylactide (PLA), polyimide (PI), and combination of the aforesaid two or above materials.

8. The luminance and color temperature tunable light source of claim 5, wherein the light conversion particles are quantum dots, and the quantum dot is selected from the group consisting of Group II-VI compounds, Group III-V compounds, Group II-VI compounds having core-shell structure, Group III-V compounds having core-shell structure, Group II-VI compounds having non-spherical alloy structure, and combination of the aforesaid two or above compounds.

9. The luminance and color temperature tunable light source of claim 5, wherein the light conversion particles are particles of a phosphor, and the phosphor is selected from the group consisting of aluminate phosphor, silicate phosphor, phosphate phosphor, sulfide phosphor, and nitride phosphor.

10. The luminance and color temperature tunable light source of claim 5, wherein an oxygen and moisture barrier is further disposed on the light conversion film, and the oxygen and moisture barrier is made of a specific material selected from the group consisting of polyethylene terephthalate (PET), polyethylene naphthalate (PEN), poly(methyl methacrylate) (PMMA), silica, titanium oxide, aluminum oxide, and combination of the aforesaid two or above materials.

11. The luminance and color temperature tunable light source of claim 1, wherein the light conversion film comprises a transparent substrate and at least one light converting coating layer formed on the transparent substrate.

12. The luminance and color temperature tunable light source of claim 1, wherein the said luminance and color temperature tunable light source can be a tube type lighting apparatus, a planar lighting apparatus, or a light bulb.

## Amended claims

### Amended claims in accordance with Rule 137(2) EPC.

1. A luminance and color temperature tunable light source, comprising:
a plurality of lighting elements, wherein each of the plurality of lighting elements is configured to emit a high color temperature light, and the plurality of lighting elements are divided into a first lighting element group and a second lighting element group;
a plurality of light conversion units, being disposed over the respective lighting elements in the second lighting element group, and being divided to a first group and a second group;
wherein the light conversion units in the first group comprise one color temperature reducing film, and the respective light conversion units in the second group comprising two or more color temperature reducing films stacked to each other;
wherein the respective light conversion unit is configured for reducing the color temperature and the luminance of the respective high color temperature lights.

2. The luminance and color temperature tunable light source of claim 1, further comprising:
a driver module, comprising a plurality of electrical connection members for being electrically connected to the lighting elements; and
a controlling module, being electrically connected to the driver module.

3. The luminance and color temperature tunable light source of claim 1, further comprising a substrate for supporting the lighting elements.

4. The luminance and color temperature tunable light source of claim 1, wherein the lighting element is selected from the group consisting of fluorescent lamp, LED, quantum dots LED, OLED, combination of aforesaid two or more devices.

5. The luminance and color temperature tunable light source of claim 1, wherein the color temperature reducing film comprises a substrate made of at least one polymer matrix and a plurality of light conversion particles doped in or enclosed by the polymer matrix.

6. The luminance and color temperature tunable light source of claim 3, wherein a circuit is disposed on the substrate for connecting between the lighting elements and the electrical connection members.

7. The luminance and color temperature tunable light source of claim 5, wherein the polymer matrix is made of a specific material selected from the group consisting of polydimethylsiloxane (PDMS), polystyrene (PS), polyethylene terephthalate (PET), polycarbonate (PC), cycloolefin co-polymer (COC), cyclic block copolymer (CBC), polylactide (PLA), polyimide (PI), and combination of the aforesaid two or above materials.

8. The luminance and color temperature tunable light source of claim 5, wherein the light conversion particles are quantum dots, and the quantum dot is selected from the group consisting of Group II-VI compounds, Group III-V compounds, Group II-VI compounds having core-shell structure, Group III-V compounds having core-shell structure, Group II-VI compounds having non-spherical alloy structure, and combination of the aforesaid two or above compounds.

9. The luminance and color temperature tunable light source of claim 5, wherein the light conversion particles are particles of a phosphor, and the phosphor is selected from the group consisting of aluminate phosphor, silicate phosphor, phosphate phosphor, sulfide phosphor, and nitride phosphor.

10. The luminance and color temperature tunable light source of claim 5, wherein an oxygen and moisture barrier is further disposed on the color temperature reducing film, and the oxygen and moisture barrier is made of a specific material selected from the group consisting of polyethylene terephthalate (PET), polyethylene naphthalate (PEN), poly(methyl methacrylate) (PMMA), silica, titanium oxide, aluminum oxide, and combination of the aforesaid two or above materials.

11. The luminance and color temperature tunable light source of claim 1, wherein the color temperature reducing film comprises a transparent substrate and at least one light converting coating layer formed on the transparent substrate.

12. The luminance and color temperature tunable light source of claim 1, wherein the said luminance and color temperature tunable light source can be a tube type lighting apparatus, a planar lighting apparatus, or a light bulb.
